(19) Europäisches Patentamt
European Patent Office
Office européen des brevets

(11) Publication number: **0 198 280 B1**

(12) **EUROPEAN PATENT SPECIFICATION**

(45) Date of publication of patent specification: **05.06.91**

(51) Int. Cl.5 **G03F 7/26**, G03F 7/075

(21) Application number: **86104055.8**

(22) Date of filing: **25.03.86**

(54) **Dry development process for metal lift-off profile.**

(30) Priority: **08.04.85 US 720781**

(43) Date of publication of application:
**22.10.86 Bulletin 86/43**

(45) Publication of the grant of the patent:
**05.06.91 Bulletin 91/23**

(84) Designated Contracting States:
**DE FR GB**

(56) References cited:
**EP-A- 0 091 651**
**EP-A- 0 136 421**
**EP-A- 0 184 567**
**EP-A- 0 136 130**
**EP-A- 0 161 476**
**WO-A-85/02030**

**J. VAC. SCI. TECHNOL. B, vol. 1, no. 4, October/December 1983, pages 1171-1173, American Vacuum Society, US; M. MORITA et al.: "Direct pattern fabrication on silicone resin by vapor phase electron beam polymerization"**

**PATENT ABSTRACTS OF JAPAN, vol. 8, no. 167 (E-258)[1604], 2nd August 1984; & JP-A-59 61 928**

(73) Proprietor: **International Business Machines Corporation**
**Old Orchard Road**
**Armonk, N.Y. 10504(US)**

(72) Inventor: **Fredericks, Edward Carmine**
**8632 Ambrose Court**
**Manassas VA 22 110(US)**
Inventor: **Kelly, Kathleen Ann**
**7700 Anderson Court**
**Manassas VA 22 110(US)**
Inventor: **Stanasolovich, David**
**8632 Madiera Court**
**Manassas VA 22 110(US)**

(74) Representative: **Kreidler, Eva-Maria, Dr. rer. nat. et al**
**Schönaicher Strasse 220**
**W-7030 Böblingen(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services

EXTENDED ABSTRACTS, vol. 82-2, October 1982, pages 321-322, abstract no. 201, Pennington, New Jersey, US; D. FOLLETT et al.: "Polarity reversal of PMMA by treatment with chlorosilanes"

JOURNAL OF THE ELECTROCHEMICAL SOCIETY, vol. 131, no. 7, July 1984, pages 1658-1664, Manchester, New Hampshire, US; G.N. TAYLOR et al.: "Gas-phase-functionalized plasma-developed resists: initial concepts and results for electron-beam exposure"

EXTENDED ABSTRACTS, vol. 83, no. 2, 1983, pages 331-332, abstract no. 211, Pennington, New Jersey, US; W.-T. LIU et al.: "PMMA resist sensitivity amplification by E-beam induced grafting of acrylic acid"

MICROELECTRONIC ENGINEERING, vol. 2, no. 4, December 1984, pages 227-243, Elsevier Science Publishers, Amsterdam, NL; B. SCHNEIDER-GMELCH et al.: "Ion-beam etched multi-level resist technique for electroplating of submicron gold absorber patterns"

PATENT ABSTRACTS OF JAPAN, vol. 8, no. 25 (E-225)[1462], 2nd February 1984; & JP-A-58 186 935

JOURNAL OF THE ELECTROCHEMICAL SOCIETY, vol. 131, no. 3, March 1984, pages 653-654, Manchester, New Hampshire, US; M. MORITA et al.: "Dry developable multilayer resist using direct pattern formation by electron beam-induced vapor-phase polymerization"

## Description

This invention relates to the field of semiconductor processing. More particularly, a dry develop process for photoresists and a metal lift-off process is disclosed.

As the ground rules for very large scale integrated circuits continually get tighter, the need for critical control over line width becomes significantly greater. Conventionally, a pattern can be created on a semiconductor wafer in a variety of ways. Typically a metallic layer is deposited on the wafer, and then a photoresist layer is applied over that first layer. Then the photoresist is exposed to some type of radiation through a mask which contains the exact pattern to be duplicated in the metallic layer. The exposure to the radiation will either make the photoresist resistant to a chemical developer or make it soluble in the developer, depending on the requirements of the pattern. In either case, the exposed photoresist layer is next immersed in a wet developer which will dissolve a portion of the photoresist layer, thereby leaving the desired mask image in the photoresist. The underlying metallic layer is suitably etched where the photoresist was dissolved, leaving the desired metallic pattern.

The conventional wet development process is not satisfactory for very large scale integration for several reasons: 1) alkaline developer is easily contaminated and attack many types of semiconductor metallurgy; 2) the development process is difficult to control since it is dependent on time, temperature, concentration, etc.; and 3) wall profiles are difficult to control.

Therefore, it is desirable to have a dry photoresist development process which can be easily controlled, is immune to contamination and allows uniform wall profiles.

From EP-A-0 136 130 a method is known which is characterized by depositing an organic layer on a substrate; by selectively irradiating said layer with actinic radiation before the sorbing of a gas containing an inorganic species, whereby a protective compound is formed in at least a portion of said layer, and by selectively removing the portion of said layer, which is not protected by said protective compound, by exposure to an oxygen plasma. In one example, using a negative photoresist containing an azide sensitizer, $SiCl_4$ is sorbed in the irradiated and in the unirradiated regions. However, the complexes formed with the sensitizer in the unirradiated regions are readily hydrolyzed upon exposure to water vapor, and a protective oxide is thus formed in the unirradiated regions. During plasma development the irradiated regions, are removed to form a "positive tone" image. Disadvantages of this method are that the inorganic halide compound reacts with groups in the irradiated as well as in the unirraditated area and that, for obtaining a difference in etch rates of irradiated and unirradiated areas, the exposure time of the resist and the duration of inorganic halide treatment are strictly limited.

From EP-A-0 184 567 a process for forming negative motives in a photoresist layer is known. In this process a photoresist layer comprising a phenol novolak resin and a diazoquinone is applied to a substrate, irradiated with UV or visible light, treated with a silicon containing compound, and developed with an oxygen plasma.

It is an object of this invention to provide a process for developing an exposed positively working photoresist layer which does not use wet chemical developers, and which can be readily dry developed in an $O_2$-plasma.

It is a further object of this invention to provide a process for developing an exposed photoresist layer which utilizes organosilicon compounds for treating the photoresist layer before etching said photoresist layer to develop the mask image.

It is a still further object of this invention to provide a process for depositing a conductor structure on the uncovered areas of the substrate.

In accordance with these objects, the invention disclosed includes the following steps:

1. Applying a thin layer of photoresist comprising a novolak resin and a naphthoquinonediazide photoactive compound (AZ 1350J) on the surface of said substrate;
2. Exposing said photoresist to radiation through a mask image;
3. Treating said exposed photoresist with an organosilicon compound such that silicon atoms bond to the exposed photoresist resulting in different etch resistance in the exposed and unexposed areas; and
4. Etching said photoresist layer to define the mask image in the photoresist layer.
5. depositing a layer of metal on the surface of said substrate, covering said remaining photoresist layer and said uncovered substrate; and
6. removing said remaining photoresist layer and said metal layer covering said photoresist layer;

whereby the conductor structure will remain deposited on the substrate.

The foregoing and other advantages of the invention will be more fully understood with reference to the description of the preferred embodiment and with reference to the drawing wherein:

Figs. 1A-F are schematic drawings illustrating the process steps of an additive metal process

according to the disclosed invention.

Figs. 2A-D are schematic drawings illustrating the process steps of a subtractive metal process according to the disclosed invention using the claimed invention.

Referring to Fig. 1A, substrate 10, which in the preferred embodiment is a semiconductor wafer, is coated with a 2 micron coating of a photoresist material 12, such as AZ1350J manufactured by Shipley Inc. Mask 14, having a pattern of radiation opaque areas 16 corresponding to desired metal lines to be deposited on substrate 10, is placed above substrate 10. Photoresist layer 12 is exposed through mask 14 to radiation such as UV light using exposure parameters well-known in the semiconductor processing art.

The resulting structure, as seen in Fig. 1B is a replication of the mask pattern in the photoresist layer 12. The exposed areas 18 of photoresist layer 12 have undergone a chemical change commonly referred to as Wolff Rearrangement, in which the chemical structure of the photoactive compound of the photoresist has changed as follows:

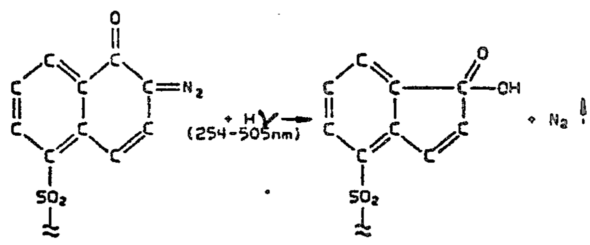


creating indene carboxylic acid groups within the photoresist.

The photoresist layer 12 is next treated with an organosilicon compound such as hexamethyldisilAzane (HMDS). The HMDS can be applied in vapor form or as a hot liquid. In one embodiment the following treatment steps have been advantageously employed:

1. Draw vacuum in over - 1.33 μbar
2. Admit HMDS vapor (99% pure) - 0.067-0.133 bar (85-95 °C)
3. Treat for 2-4 min., depending on the thickness of the photoresist and the desired treatment depth.

Aternatively, the HMDS can be applied as a hot liquid (80-90 °C) for approximately 10 minutes. The resulting structure, as seen in Fig. 1C, is a photoresist layer 12 which has been treated with HMDS to a depth D. Those indene carboxylic groups that have been treated have undergone the following chemical reaction:

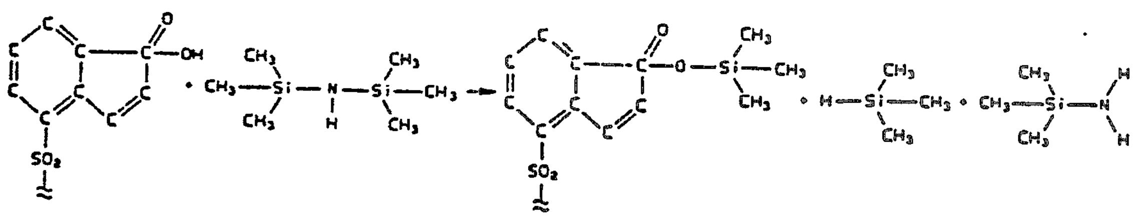

The resulting silicon-containing compound has a resistance to an oxygen etch far superior to that of the untreated photoresist. This differential in etch rates is what allows for the developing of the mask image in the photoresist without any wet etch.

Referring to Fig. 1D, the HMDS-treated photoresist layer 12 is etched using the following etch parameters:

1. $O_2$ - 100 SCCM (standard $cm^3.min^{-1}$)
2. Power - 500 watts
3. Pressure - 83.8 μbar
4. Time - approx. 9 min

Mixtures of oxygen and other gases, such as partially or totally halogenated hydrocarbons can also be used; for example a 90:10 mixture of oxygen and tetrafluoromethane (fluoroform) or a 95:5 mixture of oxygen and trichloromethane (chloroform) can also be used. The above can also be mixed with inert gases, such as argon or nitrogen to control etch rate and etch profile.

The resulting structure has the original mask pattern etched into the photoresist layer 12. In this

preferred embodiment, photoresist layer 12 was not treated with HMDS throughout its entire depth. This results in undercuts 22 in the photoresist layer 12. These undercuts allow for superior metal deposition in succeeding steps.

Following the dry develop steps, alloyed or discrete metallic layers such as copper, aluminum, gold, tungsten, platinum, palladium, titanium or molybdenum, are vapor deposited using conventional techniques.

As seen in Fig. 1E, metal 24 will be deposited in the etched areas and on the surface of photoresist layer 12. Following the removal of the remaining photoresist in a suitable solvent, any undesired metal will be washed away and the resulting metal pattern will remain as in Fig. 1F.

In an alternative embodiment the inventive dry develop process can be used in a subtractive metallic process. Referring to Fig. 2A, a substrate 30 is provided with an overlying layer of metal 32 and photoresist layer 34. The photoresist layer 34 is exposed to ultraviolet radiation through mask 36 having the desired metallic pattern to be etched in metallic layer 32.

The exposed areas 38 of photoresist layer 34 (Fig. 2B) have undergone Wolf Rearrangement as discussed above. Following treatment with HMDS as either a vapor or hot liquid as in the additive process, the unexposed areas 40 of photoresist layer 34 are preferentially etched using an oxygen etch with appropriate etch parameters. The resulting structure in Fig. 2C is a photoresist mask to be used as a mask for etching the metallic layer 32. Following a suitable etch for the metal used, as conventionally known in the art, a pattern of metal lines 42 will remain on the substrate 30 as seen in Fig. 2D.

While the invention has been particularly shown and described with the reference to particular embodiments thereof, it will be understood by those skilled in the art that various changes in detail may be made therein without departing from the spirit, scope and teaching of the invention. For example, an alternate partially halogenated organosilicon compound that will react with the indene carboxylic acid, such as N,O-bis(trimethylsilyl)-trifluoroacetamide (BSTFA) can be substituted for the HMDS. Accordingly, the process herein disclosed is to be considered merely as illustrative, and the invention is to be limited only as specified in the claims.

## Claims

1. Process for developing a mask image in a positive photoresist on a substrate and for depositing a conductor structure in the uncovered areas of said substrate comprising the steps of:
   a) providing a substrate (10);
   b) applying a thin layer of photoresist (12) comprising a novolak resin and a naphthoquinonediazide photoactive compound on the surface of said substrate;
   c) exposing said photoresist to radiation through a mask image (14, 16);
   d) treating said photoresist layer (12) with an organosilicon compound such that silicon atoms bond to the exposed photoresist (18); and
   e) etching said photoresist with an etch gas;
   whereby the unexposed photoresist will be etched at a faster rate than the exposed photoresist thereby creating the mask image in the photoresist;
   f) depositing a layer of metal (24) on the surface of said substrate, covering said remaining photoresist layer and said uncovered substrate; and
   g) removing said remaining photoresist layer and said metal layer covering said photoresist layer;
   whereby the conductor structure will remain deposited on the substrate.

2. Process of forming a pattern of metallic conductors on a substrate according to claim 1 comprising:
   a) providing a substrate (30) having a metallic layer (32) thereon; and
   in addition to steps b) to e) of claim 1 the step
   removing portions of said metallic layer (32) underlying said unexposed photoresist (40); whereby the desired conductor structure will remain deposited on said substrate.

3. Process according to claims 1 and 2, wherein said substrate (10) is silicon.

4. Process according to claims 1 and 2, wherein said organosilicon compound is hexamethyldisilazane.

5. Process according to claims 1 and 2, wherein said organosilicon compound includes at least one halogenated organosilane.

6. Process according to claim 5, wherein said organosilicon is N,O-bis (trimethylsilyl)-trifluoroacetamide.

7. Process according to claims 1 and 2, wherein the wavelength of said radiation is in the ultraviolet range.

8. Process according to claim 1 or 2, wherein said metal is selected from the group consisting of chrome, copper, aluminum, gold, tungsten, platinum, palladium, titanium and molybdenum.

9. Process according to claims 1 and 2, wherein said etch gas includes oxygen.

**Revendications**

1. Procédé pour developper une image de masque dans une photoréserve positive sur un substrat et pour déposer une structure conductrice dans les zones non recouvertes de ce substrat, caractérisé en ce qu'il comprend les étapes de:
   a) fourniture d'un substrat 10);
   b) application d'une mince couche de photoréserve (12) comprenant une résine novolaque et un composé photoactif de type naphtoquinonediazide sur la surface de ce substrat;
   c) exposition de cette photoréserve à une radiation à travers une image de masque (14, 16);
   d) traitement de cette couche de photoréserve (12) avec un composé organosilicique afin que des atomes de silicium se lient à. la photoréserve exposée (18); et
   e) attaque de cette photoréserve avec un gaz décapant, de telle sorte que la photoréserve non exposée est attaquée plus vite que la photoréserve exposée et crée ainsi l'image du masque dans la photoréserve;
   f) dépôt d'une couche de métal (24) sur la surface de ce substrat, qui recouvre cette couche de photoréserve restante et ce substrat non recouvert; et
   g) élimination de cette couche de photoréserve restante et de cette couche métallique recouvrant cette couche de photoréserve, si bien que la structure conductrice reste déposée sur le substrat.

2. Procédé pour former un motif de conducteurs métalliques sur un substrat suivant la revendication 1, caractérisé en ce qu'il comprend;
   a) la fourniture d'un substrat (30) portant une couche métallique (32); et en plus des étapes b) à e) de la revendication 1,
   l'étape d'élimination des parties de cette couche métallique (32) se trouvant en-dessous de cette photoréserve non exposée (40), si bien que la structure conductrice désirée reste déposée sur le substrat.

3. Procédé suivant les revendications 1 et 2, caractérisé en ce que ce substrat (10) est du silicium.

4. Procédé suivant les revendications 1 et 2, caractérisé en ce que ce composé organosilicique est de l'hexaméthyldisilazane.

5. Procédé suivant les revendications 1 et 2, caractérisé en ce que ce composé organosilicique comprend au moins un organosilane halogéné.

6. Procédé suivant la revendication 5, caractérisé en ce que ce composé organosilicique est le N,O-bis (triméthylsilyl)-trifluoroacétamide.

7. Procédé suivant les revendications 1 et 2, caractérisé en ce que la longueur d'onde de cette radiation est dans la gamme ultraviolette.

8. Procédé suivant les revendications 1 ou 2, caractérisé en ce que ce métal est choisi dans le groupe consistant en chrome, cuivre, aluminium, or tungsténe, platine, palladium, titane et molybdène.

9. Procédé suivant les revendications 1 et 2, caractérisé en ce que ce gaz d'attaque comprend de l'oxygène.

**Ansprüche**

1. Verfahren zum Entwickeln eines Maskenbildes in einem positiven Photolack auf einem Substrat und zum Aufbringen einer Leiterstruktur in den unbeschichteten Bereichen des Substrats, folgende Schritte

umfassend:

a) Bereitstellen eines Substrats (10);

b) Aufbringen einer dünnen Schicht Photolacks (12) bestehend aus einem Novolakharz und einer photoaktiven Naphthochinondiazidverbindung auf die Oberfläche des Substrats;

c) Belichten des Photolacks durch ein Maskenbild (14, 16)

d) Behandeln der Photolackschicht (12) mit einer Organosiliciumverbindung, so daß sich Siliciumatome mit dem belichteten Photolack (18) verbinden und

e) Ätzen des Photolacks mit einem Ätzgas,

wobei der unbelichtete Photolack schneller geätzt wird als der belichtete, wodurch in demselben das Maskenbild entsteht;

f) Aufbringen einer Schicht aus Metall (24) auf die Substratoberfläche, wodurch die restliche Photolackschicht und das unbeschichtete Substrat abgedeckt werden; sowie

g) Entfernen der restlichen Photolackschicht und der dieselbe bedeckenden Metallschicht,

wodurch die Leiterstruktur auf dem Substrat erhalten bleibt.

2. Verfahren zum Ausbilden eines Musters metallischer Leiter auf einem Substrat nach Anspruch 1, folgende Schritte umfassend:

a) Herstellen eines Substrats (30) mit einer darauf befindlichen metallischen Schicht (32) und zusätzlich zu den Schritten b) bis e) nach Anspruch 1 den Schritt,

in dem Teile der metallischen Schicht (32) unter dem unbelichteten Photolack (40) entfernt werden, wodurch die gewünschte Leiterstruktur auf dem Substrat erhalten bleibt.

3. Verfahren nach den Ansprüchen 1 und 2, wobei das Substrat (10) aus Silicium besteht.

4. Verfahren nach den Ansprüchen 1 und 2, wobei es sich bei der Organosiliciumverbindung um Hexamethyldisilazan handelt.

5. Verfahren nach den Ansprüchen 1 und 2, wobei in der Organosiliciumverbindung mindestens ein halogeniertes Organosilicium enthalten ist.

6. Verfahren nach Anspruch 5, wobei es sich bei dem Organosilikon um N,O-Bis(trimethylsilyl)-trifluoracetamid handelt.

7. Verfahren nach den Ansprüchen 1 und 2, wobei die Wellenlänge der Strahlung im ultravioletten Bereich liegt.

8. Verfahren nach Anspruch 1 oder 2, wobei das Metall aus der Gruppe von Chrom, Kupfer, Aluminium, Gold, Wolfram, Platin, Palladium, Titan und Molybdän gewählt wird.

9. Verfahren nach den Ansprüchen 1 und 2, wobei das Ätzgas Sauerstoff enthält.

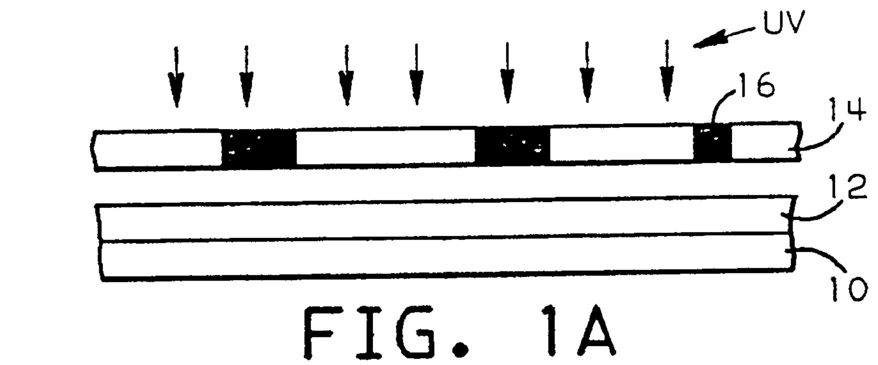

FIG. 1A

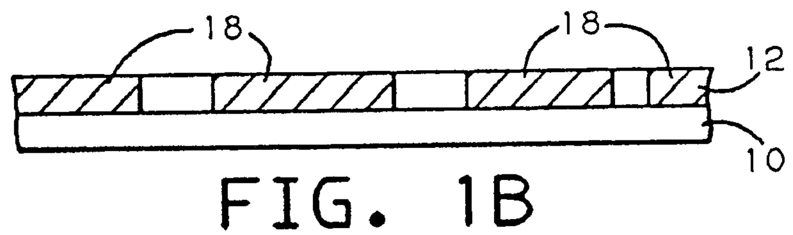

FIG. 1B

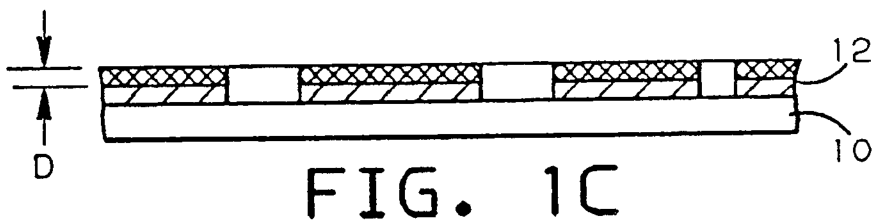

FIG. 1C

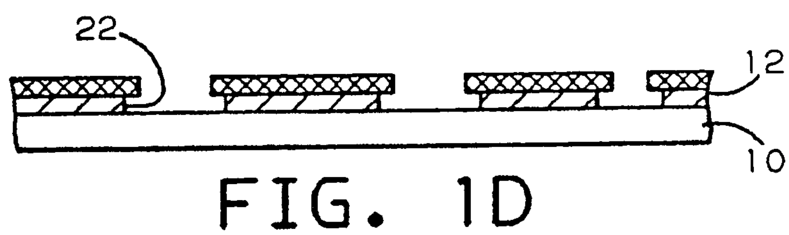

FIG. 1D

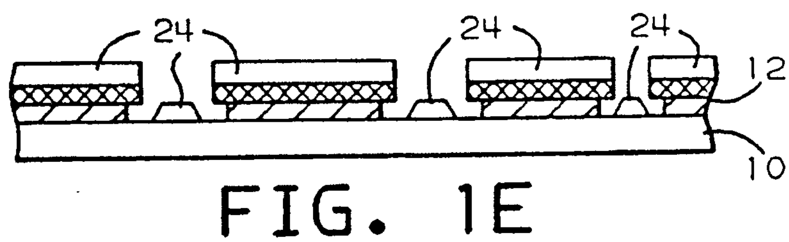

FIG. 1E

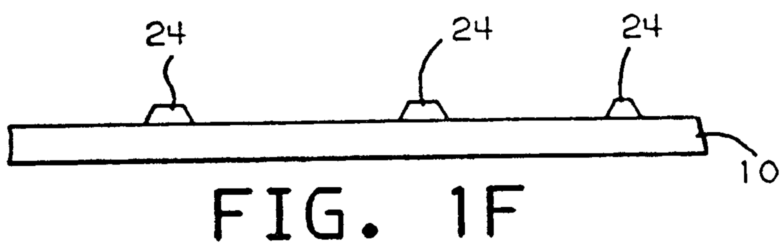

FIG. 1F

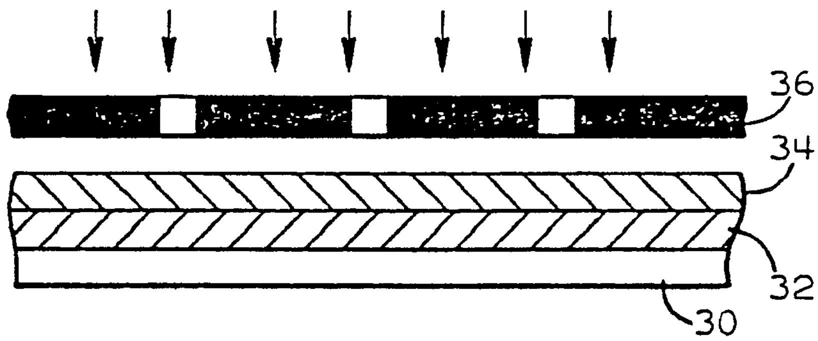


FIG. 2A

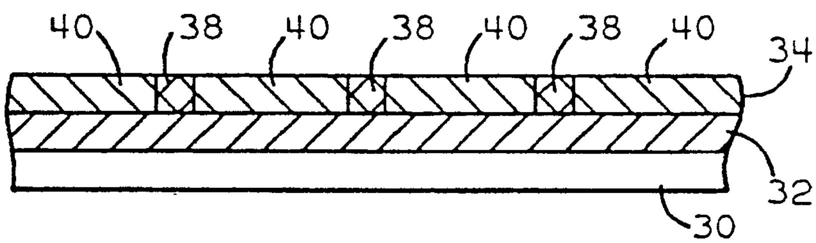


FIG. 2B

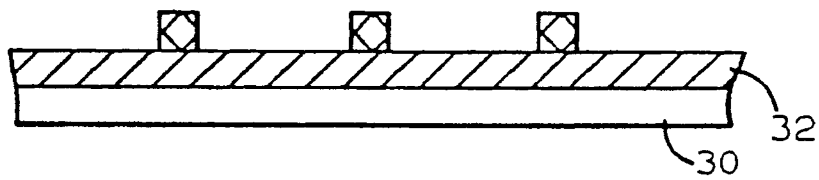


FIG. 2C

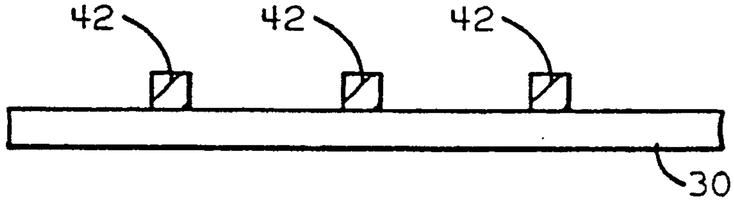


FIG. 2D